# EUROPEAN PATENT SPECIFICATION

(11) **EP 0 946 899 B1**
(45) Date of publication and mention of the grant of the patent: **16.08.2000**
(21) Application number: 96943283.0
(22) Date of filing: 23.12.1996
(51) Int. Cl.: G03F 7/20

(54) **SYSTEM FOR THE TRANSFER OF DIGITIZED IMAGES TO AN IMAGE SUPPORT OR VICE-VERSA**
SYSTEM ZUR ÜBERTRAGUNG DIGITALISIERTER BILDER AUF EINEN BILDTRÄGER ODER UMGEKEHRT
SYSTEME DE TRANSFERT D'IMAGES NUMERISEES A UN SUPPORT D'IMAGE OU VICE-VERSA

(43) Date of publication of application: 06.10.1999
(73) Proprietor: New System S.R.L., 34170 Gorizia (IT)
(72) Inventor: VODOPIVEC, Jozef, I-34170 Gorizia (IT); FUMO, Cesare, I-34170 Gorizia (IT)
(74) Representative: D'Agostini, Giovanni, Dr.
(86) International application number: PCT/IT96/00264
(87) International publication number: WO 98/28666

(56) References cited:
- WO-A-93/24326
- GB-A- 2 187 855
- US-A- 4 176 947
- US-A- 4 198 701
- US-A- 5 343 271

## Description

### Technical Field

This invention has for object a system for the transfer of digitized images on sensitive support or vice-versa.

The machine for obtaining said system is also object of the present invention.

The innovation finds particular even if not exclusive application in the field of high resolution images as for example in the making of films.

In this high resolution field the resolution is meant to be considerable, therefore of the professional type and may be rightly considered, even if not in a limitative way, as comprised within the value of 10 pixel pitch microns that is the distance between one pixel and another. Obviously by pixel is meant, in computer language, the known points which, together, compose an image. This value is also commonly defined as raster ≤10.

The process itself for the transfer of the digitized image in pixel from the computer to the machine that carries out the reproduction is here defined as process of rasterization.

One of the main purposes, even if not exclusive, is that of production of printed circuits.

However nothing prevents the system and the machine from being used in any other field in which a photographic film is required, as for example the typographical field, etc.

### Background Art

In prior art, machines for sensitizing camera films with different photosensitive materials and for a variety of purposes, are known.

The high resolution machines are substantially based on the use of a luminous head which sensitizes the photosensitive material or, in the technically more advanced solutions of a laser head.

The machine includes a cylindrical support for the photosensitive material or a flat support .

When a cylindrical support is used there are two solutions, either the drum is rotating and the head moves transversely in a to-and-fro movement, or the cylinder is fixed and is hollow, the photosensitive sheet is inserted inside it and the head is axially placed in it and moves not only alternatively in a to-and-fro movement but also rotates.

In this way with the respective movements suitably co-ordinated the digitized image is reconstructed by carrying the respective points one behind the other on the basis of the respective co-ordinates, up to the complete reconstruction of the image.

The solution on flat support is less used because it is considered complex and expensive, if compared to the previous ones and utilizes substantially the same principle, with the difference that it works as a plotter in which the plotting head moves on said surface along the respective co-ordinates, just like a drawing plotter in a computer.

X-Y movement of image support material is eg. disclosed in GB-A-2187855.

The idea is to use a plurality of illuminable sources eg. disclosed in WO-A-93/24326, but with a new method to allow a strong reduction in work.

All these solutions are expensive and difficult and in any case, require lengthy reproduction times.

The resolution is obviously higher in the laser versions, but the time and costs for the purchase and maintenance of the machine remain very high, also because of the presence of substantial mechanical parts in movement.

Analyzing these types of machines in all of them can be noticed the presence of only one operating head that can send one or more points at a time, in logic succession up to completion of the entire image on the surface chosen for the exposure, starting for example from an upper angle until reaching the lower diametrically opposite angle.

The logic succession of these steps makes practically impossible to increment considerably the operative speeds.
- GB-2187855 as previously anticipated, discloses a photoplotter using light valve device using a single light source, a support for a sheet of photosensitive material for exposure and a light valve device interposed between the light source and the sheet, to divide the sheet image in a plurality of spaced subareas or pixels, the light transmissivity of which are individually controlled through an associated computer to cause the exposure to be that of a desired graphic or artwork. The light valve device may be moved relative to the sheet to expose areas corresponding to those originally associated with the space between the pixels.

This solution is very interesting but has the drawback of not being able to control the entire figure because of the shadow of said light valve device.
- WO-A-93/24396 as previously anticipated, discloses a method and device for retaining a thin medium between two bodies.

In particular, with a view to faster and better exposure of the medium, electronic chips have been developed by means of which a plurality of selectively modulable light channels can be romed. These chips may be used for building a rod transversely to the medium for exposure, so that the medium is illuminated in a coherent line in its entire width (US4899222, US5030970, GB187855). Starting from these teachings, the aim of this invention is that of avoiding the above-mentioned drawbacks, and in particular of making an inexpensive, reliable, fast machine, that requires minimum maintenance and is easy to use and in which the resolution level can be the highest, that is without endangering in any way a necessary suitable resolution level as mentioned above, using the teaching of US 4176947 discloses a step and repeat mechanism. In particular it regards an apparatus for moving sheet material, primarily microfiche, into a plurality of X and Y axis position by means of a gas cushion formed on a plate in which the sheet material is shifted by means of ducted gas jets or sweeps.

This and other aims are reached as claimed by a system for the transfer of digitized images from a computer to an optionally photosensitive image support material or vice-versa, using illuminable punctiform sources, characterised in that it comprises:
- active flat plate exposure means or detectors for said image support material, on which can be placed said image support material, which plate comprises a plurality of (n) illuminable sources of punctiform exposure means or detectors, placed thereon in a fixed way with one source per square in a raster of (n) squares, connected/connectable to the computer system respective to the digital image to be treated, and enabling, with suitable software, one or the other of said punctiform exposure means or detectors to be illuminably scanned according to the digitized image to be transferred, whereby only one point, corresponding to only one pixel for square (n) is addressed at any time, each square (n) of the raster being able to include a plurality of pixels or points of the image equal to (x), so that the total of the pixels or points of the entire image is equal to (nx).
- support means for the image support material on said active plate exposure means, and
- means for the movement of said active plate and/or of said image support material, allowing the movement of one of these with respect to the other one, according to digitized co-ordinates corresponding to at least a square (n) of the entire image to be digitized, and to activate for successive points of said square (n), the corresponding illuminable sources (n) of punctiform exposure means or detector, each time and step by step so that each said source (n) (11) exposes/scans the entire surface corresponding to its own square (n) of the material to be sensitized, in order to obtain a sensitized square (n) of the image support material, and further in order to obtain the desired entire image with the aid of the further (n) illuminable sources, each located in its corresponding square (n) of the raster.

In this way there is the immediate advantage to increase the transfer and sensitizing speed as many times as the sections of the raster (n) times.

This obviously considering the theoretic side and the fact that the electronic transfer operation moves at the speed of light.

Considering further, that there is a more complex processing and calculation, the operative times are reduced by more than 70%, with the further advantage of an important simplification of the system, lower manufacturing costs (for the active plate, common "LED" suffice ) etc.

Advantageously the movement is communicated to the photosensitive sheet that is kept suspended among the active plate and counter-plate in a cushion of air.

In this way the movement is very slight, fast and quick and does not involve considerable moving masses.

Furthermore the photosensitive material does not touch the surface of the active plate and is not damaged.

Advantageously said air bearing is made by means of a plurality of punctiform air-jets made in the opposite plates so that the sheet is kept suspended between the two surfaces, while the movement mechanism will clamp the sheet only on one side for its simple and limited movement.

These and other advantages will appear from the following embodiments with the aid of the included drawings whose details are not to be considered limitative but only supplied as an example.

Figure 1 is a schematic front view of the sensitizing active plate;

Figure 2 is an enlarged view of an "n" portion of the sub-division raster that theoretically is made up of the image to be copied, including a plurality "x" of points or pixels that make up the image.

Figure 3 is a cross sectional schematic view of the machine involving the active plate, its counter-plate and the mechanism with the respective sensitizing sheet suspended and moved between the two plates.

Figure 4 is a schematic view of the movement scheme for the transfer of the image from the computer to the sensitive support, the inverse operation in a like and symmetric way being possible. With regard to the above mentioned Figures, it is disclosed that: With 1, the active plate is indicated which includes in it a reticulation of "n" squares, each involving an illuminable LED according to program (11) able to sensitize in a punctiform way a photosensitive film to be exposed (3) that is placed between said active plate 1 and a counter-plate 2.

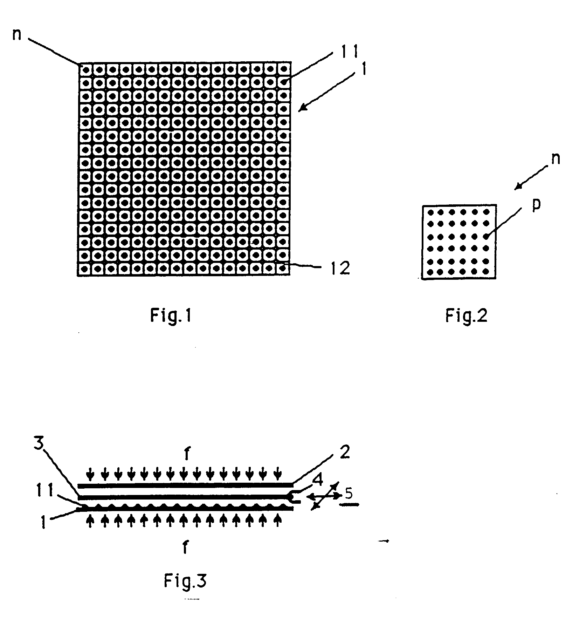

Both the active plate 1 and the counter-plate 2 are equipped with a plurality of holes (12) preferably uniformly distributed that launch an opposite compressed air jet (f), in order to allow the support of a sheet suspended between them, self-centred in a respective air bearing, as schematically visible in Fig.3.

Advantageously the air jet holes are placed in-between the exposure LED 11 of the film 3.

The film or photosensitive sheet to be exposed (3) is introduced between the plates 1 and 2 by a loader as in prior art and clamped by a clamp or suitable clamping means 4, is therein kept suspended.

The plates in particular, are approached in a guide position and the active plate 1 is also in the position with the respective LED (11) to expose the film 3.

The support of the film 4 is movable by using means of the prior art shaped as a plotter to operate by scanner system the transfer of the image.

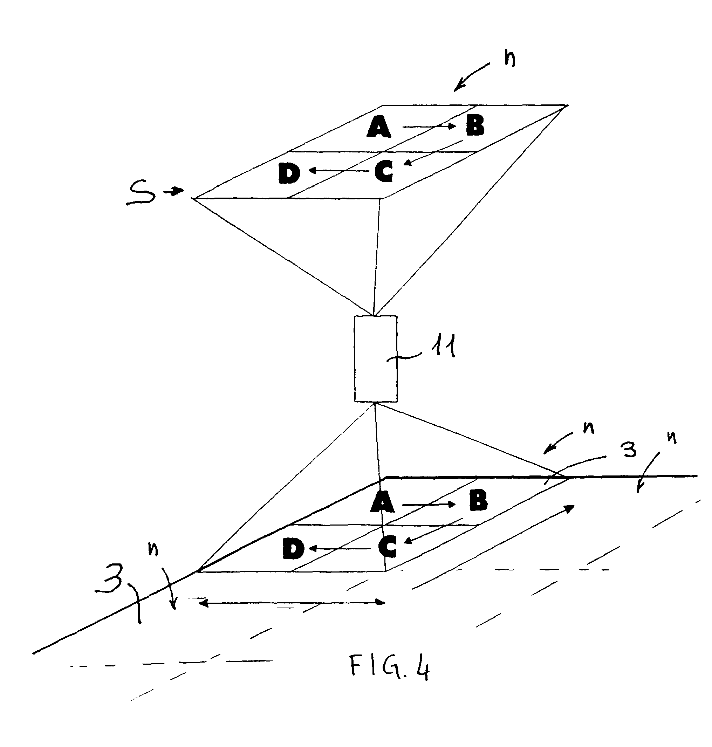

As disclosed in Fig.4, the image in the computer S, is divided in a plurality of sectors , as on a draughtboard, in which each sector of the respective raster "n" is a portion to be scanned.

The operation may also be carried out digitally by a control software and in this way a specular movement A-B-C-D will be obtained, that by translators, decoders and encoders and processors, will be suitably transmitted on the film of the photosensitive sheet 3 or vice-versa with an inverse process.

Coming back to the inventive concept, as mentioned, the invention relates to a system for the transfer of digitized images from a computer (S) to a photosensitive support (3) or vice-versa, characterised in that it comprises:
- active flat plate exposure means (1) of said photosensitive material (3), on which can be placed said photosensitive material (3) that must be exposed, which involves a plurality of (n) illuminable sources of punctiform exposure (11), arranged in fixed way in a raster of (n) squares, connected/connectable to the computer system (S) relative to the digital image, and able, with a suitable software, to be one or the other (11) lighted according to the digitized image to be transferred, but carrying only one point (p), corresponding to only one pixel (p) per square (n) at a time, each square (n) of the raster being able to include a plurality of pixels or points of the image equal to (x), and so that the total of the pixels or points of the entire image is equal to (nx).
- support means (4) of the photosensitive material (3) on said active plate exposure means (1), and
- movement means (5) of said active plate (1) and/or of said photosensitive material (3), able to move the one and/or the other of one of them in respect to the other one, according to digitized co-ordinates corresponding to at least said portion (n) of the entire image to be digitized, and to activate by successive points said illuminable sources of punctiform exposure, each time and step by step for the exposure on said photosensitive material (3), so that each source sensitizes the entire surface corresponding to its own square (n) of the material to be sensitized, and this in order to obtain the desired entire image with the aid of the (n) luminous sources, for this purpose each dislocated in connection with each square (n) of the raster.

The system obviously is embodied in a machine that includes two opposite plates, an active one for the sensitization of the photosensitive sheet and an opposite one.

Both these plates have opposite air jet holes to support the photosensitive sheet (film between them).

A clamping system of the sheet between the plates will provide its movement.

More particularly, referring to the Figures it is disclosed that the photosensitive sheet is simply inserted between the two surfaces, one of which represents the support of the numerous light sources.

The light sources are arranged in order to cover the entire surface of the photosensitive sheet (film).

The relative displacement between film and light sources, allows to light any point of the film and therefore to sensitize it with the digitized image as wished and in the desired resolution level.

The machine consists of a pedestal inside of which is placed a box with the films and the system for their loading (the system is not described but it is of prior art as for example those used in the automatic sheet loaders).

For the transfer of each sheet in the exposition area inside of the said opposite plates .

The film is fixed before the exposure, in a biaxial movement system.

From the nozzles of the plates jets of air come out that keep the sheet always centred preventing its contact with the opposite surfaces.

The plates are placed one close to the other but avoiding contact so that a cushion of air is obtained between the surfaces in relative movement.

The system may be made operative by a suitable software that will have the onus of giving instructions on the use, that is:
- collect the digital data of the image;
- prepare them in a way corresponding to the size and resolution required by the exposure device, so that they can be transmitted to the single light modulators, in correlation to the path that they describe in the exposure process.

The input to the exposure process is always given digitally.

The original image can be digitized also starting from a simple photo or similar support, by using scanners or other image digitizers.

If the image is supplied with vectorial data, this is rasterized by using the exposure resolution.

Before beginning the exposure process, it is necessary to adapt the size and the resolution of the image to the size and the variable parameters of the exposure device.

The ratio pixel : pixel is established.

This is determined by the mechanical characteristics of the exposure device, and of the measurement of the original image.

Thus a "bitmap" type image is obtained.

This can reduce the space needed and also be in a compressed shape.

As a result, the image is divided in single sectors corresponding to the square positions (n).

Additionally, the data of each sector are sorted in a sequence corresponding to the movement between exposure device and exposed object.

The data are transmitted to the single modulators (light sources) in synchronism with the relative displacement of position, in order to cover the entire surface of the area to be elaborated.

The displacement of the films occurs on two axes.

The pitch of the displacement also defines the resolution that the machine is able to give, and which can be different for each axis.

The stroke of each of the two axes is determined by the distance between the two adjacent points (spots).

When the path on the first axis ends, the second axis is displaced by one pitch.

The exposure ends when the second axis completes the entire stroke.

It must be highlighted that the solution adopted allows a displacement of the film with masses in minimum movement.

As the stroke is defined by the distance between the luminous beam "spots", this can be reduced to the minimum.

Thus is obtained a highly reduced total time of exposure and a precision certainly higher if compared to the traditional solutions.

Of course the system can also be utilized in an inverse way, that is for transferring a graphic image from a respective external support (e.g. paper) to the computer always as a digitized image.

## Claims

1. System for the transfer of digitized images from a computer (S) to an optionally photosensitive image support material (3) or vice-versa, using illuminable punctiform sources, characterised in that it comprises:
- active flat plate exposure means or detectors (I) for said image support material (3), on which can be placed said image support material (3), which plate comprises a plurality of (n) illuminable sources of punctiform exposure means or detectors (11), placed thereon in a fixed way with one source per square in a raster of (n) squares, connected/connectable to the computer system (S) respective to the digital image to be treated, and enabling, with suitable software, one or the other of said punctiform exposure means or detectors (11) to be illuminably scanned according to the digitized image to be transferred, whereby only one point (p), corresponding to only one pixel (p) for square (n) is addressed at any time, each square (n) of the raster being able to include a plurality of pixels or points of the image equal to (x), so that the total of the pixels or points of the entire image is equal to (nx).
- support means (4) for the image support material (3) on said active plate exposure means (1), and
- means for the movement (5) of said active plate (1) and/or of said image support material (3), allowing the movement of one of these with respect to the other one, according to digitized co-ordinates corresponding to at least a square (n) of the entire image to be digitized, and to activate for successive points of said square (n), the corresponding illuminable sources (n) of punctiform exposure means or detector, each time and step by step so that each said source (n)(11) exposes/scans the entire surface corresponding to its own square (n) of the material to be sensitized, in order to obtain a sensitized square (n) of the image support material (3), and further in order to obtain the desired entire image with the aid of the further (n) illuminable sources, each located in its corresponding square (n) of the raster.

2. System according to claim 1,2, characterised in that the movement is communicated to the photosensitive sheet (3) that is kept suspended between active plate (1) and a counter-plate (2) in a cushion of air.

3. System according to claim 3, characterised in that said cushion of air is obtained by means of a plurality of punctiform air-jets (12-f) made in the opposite plates (1,2) so that said photosensitive sheet (3) will be kept suspended between the two surfaces,

4. System according to claim 3, characterised in that the movement mechanism (4-5) clamps the sheet only on one side.

5. Machine for the transfer of digitized images from a computer (S) to a photosensitive support in sheet (3), realised and operating according to the system mentioned in the previous claims, characterised in that it comprises:
- an active plate (I) with a plurality of exposure luminous sources (11) for photosensitive material, activable or not in illumination, one independently from the other;
- means to support a photosensitive sheet over said plate (4-12-f);
- means for moving alternatively said sheet (4-5) at least in respect to said active plate (1) or vice-versa;
- said machine being associated or associable to means to turn on and off in a programmed way said exposure luminous sources.

6. Machine for the transferring of digitized images from a computer (S) to a photosensitive support in sheet (3) realised and operating according to the system mentioned in the previous claims, characterised in that it comprises:
- an active plate (1) with a plurality of exposure luminous sources (11) for photosensitive material (3), activable or not in lightning independently one from the other;
- a counter-plate (2) spaced by the first (I) and leaving a space for receiving a sheet or photosensitive film (3),
- means (12) for letting in air in opposition (f) between the surfaces and therefore maintaining said sheet (3) suspended among these (1,2);
- means for moving alternatively said sheet (3) at least in respect to said active plate (1);
- said machine being associated or associable to means to turn on and off in a programmed way said exposure luminous sources (11).

7. Machine according to the previous claim, characterised in that it comprises an automatic loader of the sheets between said plates.

## Patentansprüche

1. System für den Transfer von digitalisierten Bildern von einem Computer (S ) zu einem auf Wunsch lichtempfindlichen Bildträger-Material (3) oder umgekehrt, indem man beleuchtbare punktförmige Quellen verwendet, gekennzeichnet dadurch, dass es umfasst:
- aktive flache PlattenBelichtungs-Mittel oder Detektoren (1) für besagtes Bildträger-Material (3), auf welche besagtes Bildträger-Material (3) gelegt werden kann, wobei die Platte eine Anzahl von (n) beleuchtbaren Quellen von punktförmigen Belichtungsmitteln oder Detektoren (11) umfasst, fest darauf plaziert mit einer Quelle pro Quadrat in einem Raster von (n ) Quadraten. verbunden/verbindbar mit dem Computersystem (S) entsprechend dem zu behandelnden digitalen Bild, und die, mit geeigneter Software, das eine oder andere von besagten punktförmigen Belichtungsmitteln oder Detektoren (11) dazu befähigt, mittels Beleuchtung gemäß dem zu übertragenden digitalisierten Bild abgetastet zu werden, wodurch nur ein Punkt (p), der nur einem Pixel (p ) pro Quadrat (n ) entspricht, jeweils angesprochen wird und jedes Quadrat (n ) des Rasters fähig ist, eine Anzahl von Pixeln oder Punkten des Bildes gleich (x) zu umfassen, so daß die Gesamtzahl der Pixel oder Punkte des ganzen Bildes gleich (nx) ist.
- Trägermittel (4) für das Bildträger-Material (3) auf besagten aktiven Platten-Belichtungs-Mitteln (1), und
- Mittel für die Bewegung (5) von besagter aktiver Platte (1) und/oder von besagtem Bildträger-Material (3), die die Bewegung von einer von diesen in bezug auf die andere erlaubt, gemäß digitalisierte halbpolaren entsprechend mindestens einem Quadrat (n ) des ganzen zu digitalisierenden Bildes, und zur Aktivierung. für darauffolgende Punkte von besagtem Quadrat (n), der entsprechenden beleuchtbare Quellen (n) punktförmiger Belichtungsmittel oder Detektor, jedesmal und Schritt um Schritt. so dass jede besagte Quelle (n) (11) die ganze Oberfläche belichtet/abtastet, die ihrem eigenen Quadrat (n) des zu sensibilisierenden Materials entspricht, um ein sensibilisiertes Quadrat (n ) von dem Bildträger-Material (3) zu erhalten, und weiter, um das erwünschte ganze Bild mit Hilfe der weiteren (n ) beleuchtbaren Quellen zu erhalten, jede lokalisiert in ihrem entsprechenden Quadrat (n ) des Rasters.

2. System nach Anspruch 1,2, gekennzeichnet dadurch, dass die Bewegung der lichtempfindlichen Folie (3) übermittelt wird, die zwischen der aktiven Platte (1) und einer Gegenplatte (2) in einem Luftkissen aufgehängt ist.

3. System nach Anspruch 3, gekennzeichnet dadurch, dass dieses besagte Luftkissen mittels eine Anzahl von punktförmigen Luftstrahlen (12-f) erhalten wird, die in den gegenüberliegenden Platten gemacht (1,2) werden, so dass besagte lichtempfindliche Folie (3) zwischen den beiden Oberflächen aufgehängt ist,

4. System nach Anspruch 3, gekennzeichnet dadurch, dass der Bewegungsmechanismus (4-5) die Folie nur auf einer Seite klammert.

5. Maschine für den Transfer von digitalisierten Bildern von einem Computer (S) zu einem lichtempfindlichen Träger aus Folie (3), erzeugt und arbeitend gemäß dem System, das in den vorherigen Patentansprüchen erwähnt ist, gekennzeichnet dadurch, dass sie umfasst:
- eine aktive Platte (1) mit einer Anzahl von leuchtenden Belichtungsquellen (11) für lichtempfindliches Material. aktivierbar oder nicht zur Beleuchtung, die eine unabhängig von der anderen;
- Mittel um eine lichtempfindliches Folie über besagter Platte (4-12-f) zu halten;
- Mittel zum alternativen Bewegen besagter Folie (4-5) mindestens in bezug auf besagte aktive Platte (1) oder umgekehrt;
- wobei besagte Maschine mit Mitteln verbunden oder verbindbar ist, um besagte leuchtende Belichtungsquellen auf programmierte Art ein- und auszuschalten.

6. Maschine für die Übertragung von digitalisierten Bildern von einem Computer (S) zu einem lichtempfindlichen Träger aus Folie (3), erzeugt und arbeitend gemäß dem System, das in den vorherigen Patentansprüchen erwähnt ist, gekennzeichnet dadurch, dass sie umfasst:
- eine aktive Platte (1) mit einer Anzahl von leuchtenden Belichtungsquellen (11) für lichtempfindliches Material (3), unabhängig voneinander zur Beleuchtung aktivierbar oder nicht;
- eine Gegenplatte (2) in Abstand zur ersten (1), die einen Raum zur Aufnahme einer Folie oder eines lichtempfindlichen Films (3) freilässt,
- Mittel (12) zum Einlassen von Luft gegenüber (f) zwischen den Oberflächen, so dass besagte Folie (3) zwischen diesen (1.2) aufgehängt bleibt;
- Mittel zum alternativen Bewegen besagter Folie (3) mindestens in bezug auf besagte aktive Platte (1);
- wobei besagte Maschine mit Mitteln verbunden oder verbindbar ist, um besagte leuchtende Belichtungsquellen auf programmierte Art ein- und auszuschalten (11).

7. Maschine gemäß dem vorherigen Anspruch, gekennzeichnet dadurch, dass sie einen automatischen Lader der Folien zwischen besagten Platten umfasst.

## Revendications

1. Système pour le transfert d'images numérisés d'un ordinateur (S) à un matériel de support d'image optionnellement photosensible (3) ou vice versa, en utilisant des sources ponctuelles illuminables, caractérisé en ce qu'il comprend:
- moyen d'exposition actif à assiette plate ou détecteurs (1) pour ledit matériel de support d'image (3), sur lequel ledit matériel de support d'image (3) peut être placé, laquelle assiette comprend une pluralité de (n) sources illuminables de moyens d'exposition ponctuels ou détecteurs (11), placés là-dessus de façon fixée avec une source pour chaque carré dans un réseau de (n) carrés, connecté/connectible au système d'ordinateur (S) respectif à l'image digital à traiter, et permettant, avec un logiciel approprié, l'un ou l'autre desdits moyens d'exposition ponctuels ou détecteurs (11) à être scruté par illumination selon l'image numérisé à transférer, de façon qu'un seul point (p), correspondant à un seul pixel (p) pour le carré (n) est adressé en n'importe quel moment, chaque carré (n) du réseau pouvant inclure une pluralité de pixels ou points de 1' image égaux à (x), afin que le total de pixels ou points de l'image entier soit égal à (nx).
- moyen de support (4) pour le matériel de support d'image (3) sur ledit moyen d'exposition à assiette active (1), et
- moyen pour le mouvement (5) de ladite assiette active (1) et/ou dudit matériel de support d'image (3), qui permettent) le mouvement d'un de ces deux par rapport à l'autre, selon des coordonnées numérisées correspondant à au moins un carré (n) de l'image entier à numériser, et pour activer pour des points successifs dudit carré (n), les sources illuminables correspondantes (n) du moyen d'exposition ponctuel ou du détecteur, chaque fois et de pas en pas afin que chacune desdits sources (n) (11) expose/scrute la surface entière qui correspond à son propre carré (n) du matériel à sensibiliser, afin d'obtenir un carré sensibilisé (n) du matériel de support d'image (3), et en plus afin d'obtenir l'image entier désiré à l'aide des autres (n) sources illuminables, chacune localisée dans son carré correspondant (n) du réseau.

2. Système selon la revendication 1,2, caractérisé en ce que le mouvement est communiqué à la feuille photosensible (3) qui est tenue suspendue entre l'assiette active (1) et une contre-assiette (2) dans un coussin d'air.

3. Système selon la revendication 3, caractérisé en ce que ledit coussin d'air est obtenu moyennant une pluralité de jets d'air ponctuels (12-f) faits dans les assiettes opposées (1,2) afin que ladite feuille photosensible (3) sera tenue suspendue entre le deux surfaces,

4. Système selon la revendication 3, caractérisé en ce que le mécanisme de mouvement (4-5) serre la feuille d'un seul côté.

5. Machine pour le transfert d'images numérisés d'un ordinateur (S) à un support photosensible en feuille (3), réalisé et opérant selon le système mentionné dans les revendications précédentes, caractérisée en ce qu'elle comprend:
- une assiette active (1) avec une pluralité de sources lumineuses d'exposition (11) pour du matériel photosensible, activable ou ne pas activable en illumination, l'un indépendamment de l'autre;
- moyen pour supporter une feuille photosensible au-dessus de ladite assiette (4-12-f);
- moyen pour le mouvement alternatif de ladite feuille (4-5) au moins par rapport à ladite assiette active (1) ou vice versa;
- ladit machine étant associée ou associable à des moyens pour allumer et fermer de façon programmée lesdits sources d'exposition lumineuse.

6. Machine pour le transfert d'images numérisées d'un ordinateur (S) à un support photosensible en feuille (3), réalisé et opérant selon le système mentionné dans les revendications précédentes, caractérisée en ce qu'elle comprend:
- une assiette active (1) avec une pluralité de sources d'exposition lumineuse (11) pour du matériel photosensible (3), activable ou non en illumination indépendamment l'un de l'autre;
- une contre-assiette (2) espacée par rapport à la première (1) et laissant un espace pour recevoir une feuille ou une pellicule photosensible (3),
- moyen (12) pour laisser entrer de l'air en opposition (f) entre les surfaces et par conséquent maintenant ladite feuille (3) suspendue parmi elles (1,2);
- moyen pour le mouvement alternatif de ladite feuille (3) au moins par rapport à ladite assiette active (1);
- ladite machine étant associée ou associable à des moyens pour allumer et fermer de façon programmée lesdites sources d'exposition lumineuse (11).

7. Machine selon la revendication précédente, caractérisée en ce qu'elle comprend un chargeur automatique des feuilles entre lesdites assiettes.
